# FASCICULE DE BREVET EUROPEEN

(11) **EP 2 824 620 B1**
(45) Date de publication et mention de la délivrance du brevet: **17.10.2018**
(21) Numéro de dépôt: 14176227.8
(22) Date de dépôt: 09.07.2014
(51) Int. Cl.: G06Q 20/00, G07G 1/12, G07G 1/00, B65D 55/06, H05K 5/00

(54) **Terminal de paiement électronique comprenant un système de verrouillage du boitier amélioré**
Elektronisches Zahlungsendgerät, das ein verbessertes Verriegelungssystem des Gehäuses umfasst
Electronic payment terminal including an improved system for locking the housing

(30) Priorité: 12.07.2013 FR 1356905
(43) Date de publication de la demande: 14.01.2015
(73) Titulaire: Ingenico Group, 75015 Paris (FR)
(72) Inventeur: Janot, Cyril, 26400 Grane (FR); Andre, Jérôme, 26800 Montoison (FR); Soubirane, Alain, 26500 Bourg-les-Valence (FR); Maisonnat, Serge, 26600 Mercurol (FR)
(74) Mandataire: Vidon Brevets & Stratégie

(56) Documents cités:
- FR-A1- 2 193 749
- FR-A1- 2 650 566
- US-A- 3 990 131

## Description

### 1. Domaine de l'invention

Le domaine de l'invention est celui des terminaux de paiement électronique. En particulier, la présente invention se rapporte au domaine des boitiers de tels terminaux de paiement électroniques.

### 2. Art antérieur

A l'heure actuelle, les terminaux de paiement électroniques sont majoritairement utilisés pour permettre le règlement des achats de biens et de services au sein des points de vente. Un tel terminal comprend généralement un lecteur de carte à puce et un lecteur de carte magnétique. Ils comprennent également un écran, permettant notamment de visualiser des informations telles que les montants des transactions, et un clavier de saisie de ces mêmes montants ainsi que des codes confidentiels saisis par les clients, ou bien un écran tactile. Le terminal comprend également des composants électroniques rassemblés dans une ou plusieurs enceintes sécurisées. Tous ces composants sont inclues dans un boitier, généralement construit à partir d'une demi-coque supérieure et d'une demi-coque inférieure, emboitées l'une sur l'autre. Ces deux demi-coques sont ensuite solidarisées avec des vis.

Il s'est avéré, cependant, qu'un tel assemblage, dit translatif, réalisé en posant une demi-coque par-dessus une autre demi-coque, n'empêche pas totalement l'ouverture du boitier du terminal. Il est en effet possible, une fois les vis d'assemblage enlevées, de soulever légèrement une des demi-coques pour avoir accès à l'ensemble des composants du terminal. Des commerçants peu scrupuleux ou des pirates en quête de données de cartes bancaires, peuvent ainsi être tentés de rendre inopérants certains des composants, par exemple dans le but de frauder les administrations fiscales.

Il existe donc un besoin de fournir des solutions permettant d'éviter ce type de fraude.

### 3. Objectifs de l'invention

La présente invention a pour objectif de palier ces inconvénients de l'art antérieur.

En particulier, la présente invention a pour objectif de fournir un terminal de paiement électronique dont le boitier ne puisse pas être ouvert sans laisser de trace indélébile de cette ouverture.

Un autre objectif de l'invention est de fournir un tel terminal dont le boitier empêche efficacement l'accès aux composants contenus dans le boitier, tant que le boitier n'est pas ouvert.

L'invention a encore pour objectif de fournir un tel terminal dont le montage soit facile, et qui soit peu onéreux.

### 4 . Exposé de l'invention

Ces objectifs, ainsi que d'autres qui apparaîtront plus clairement par la suite sont atteints à l'aide d'un terminal de paiement électronique comprenant un boitier formé de deux demi-coques superposées l'une à l'autre, caractérisées en ce que chacune desdites demi-coques présente un élément de paroi dans lequel est percée une ouverture de verrouillage, les ouvertures de verrouillage de chacune desdites demi-coques étant superposées l'une à l'autre, et en ce que ledit boitier comprend une cheville de verrouillage, insérée dans lesdites deux ouvertures de verrouillage superposées afin d'empêcher le déplacement relatif desdits éléments de paroi, dans un plan perpendiculaire à l'axe longitudinal de ladite cheville.

Ce mode de verrouillage des demi-coques formant le boitier permet d'assurer une plus grande sécurité du terminal. En effet, il est nécessaire, pour ouvrir le boitier, de retirer préalablement la cheville de verrouillage.

Le terminal de paiement électronique comprend une vis de fixation de ladite cheville audit boitier.

Avantageusement, ladite vis est introduite dans un perçage axial prévu dans ladite cheville.

Avantageusement, ladite cheville présente un lamage, au-dessus de la tête de ladite vis, dans lequel est introduit un sceau de contrôle.

Ce lamage, qui est prévu au dessus de la tête de vis, permet donc que la tête de vis soit dissimulée dans la goupille. Par ailleurs, le sceau de contrôle, ou scellé, qui est introduit dan ce lamage dissimule la tête de vis, et empêche l'accès à celle-ci. Il est donc impossible de démonter les deux demi-coques formant le boitier sans détruire préalablement le sceau de contrôle.

Avantageusement, ledit lamage présente une rainure interne assurant une solidarisation efficace dudit sceau de contrôle.

Une telle rainure permet en effet une meilleure tenue mécanique du sceau de contrôle, par exemple réalisé en plomb qui est introduit par frappage, dans le lamage.

Avantageusement, ledit boitier présente, à proximité de ladite cheville, une surface d'appui dans l'axe de ladite cheville, sensiblement perpendiculaire à cet axe et orienté dans un sens opposé au sens d'ouverture dudit lamage, permettant de former appui pour l'introduction par frappage dudit sceau de contrôle dans ledit lamage.

Il est ainsi possible de mettre en place facilement le sceau, par frappage, en plaçant la surface d'appui sur une enclume. Le frappage ne risque alors pas de détériorer le terminal.

Avantageusement, lesdites ouvertures de verrouillage des deux demi-coques sont constitués par des anneaux de verrouillage formés par lesdits éléments de paroi.

L'invention concerne également un procédé d'assemblage du boitier d'un terminal de paiement électronique, caractérisé en ce qu'il comprend :
- une étape d'assemblage de deux demi-coques, jusqu'à ce qu'un élément de paroi d'une première demi-coque, dans lequel est définie une première ouverture de verrouillage, soit placé en regard d'un élément de paroi de la seconde demi-coque dans lequel est définie une seconde ouverture de verrouillage ;
- une étape d'insertion d'une cheville dans lesdites deux ouvertures de verrouillage.

Un tel procédé permet un verrouillage facile et efficace du terminal.

### 5. Liste des figures

D'autres caractéristiques et avantages de l'invention apparaîtront plus clairement à la lecture de la description suivante d'un mode de réalisation particulier, donné à titre de simple exemple illustratif et non limitatif, et des dessins annexés, parmi lesquels :
- la figure 1 est une vue en perspective, de dessus, d'un terminal de paiement électronique selon un mode de réalisation de l'invention ;
- la figure 2 est une vue en perspective, de dessous, du terminal de la figure 1 dont la demi-coque supérieure et la demi-coque inférieure ne sont pas assemblées ;
- la figure 3 est une vue de détails, en perspective, d'une première extrémité de la demi-coque inférieure du terminal des figures 1 et 2 ;
- la figure 4 est une vue de détails, en perspective, d'une première extrémité de la demi-coque supérieure du terminal des figures 1 et 2 ;
- la figure 5 est une vue de coupe, en perspective, de la première extrémité de la demi-coque inférieure et de la première extrémité de la demi-coque supérieure au cours de l'assemblage de ces deux demi-coques ;
- la figure 6 est une vue de coupe, en perspective, de la première extrémité de la demi-coque inférieure et de la première extrémité de la demi-coque supérieure quand ces demi-coques sont assemblées ;
- la figure 7 est une vue en perspective de la seconde extrémité de la demi-coque inférieure et de la seconde extrémité de la demi-coque supérieure, pendant l'assemblage de ces deux demi-coques ;
- la figure 8 montre la seconde extrémité de la demi-coque inférieure et la seconde extrémité de la demi-coque supérieure assemblées pour former le boitier du terminal ;

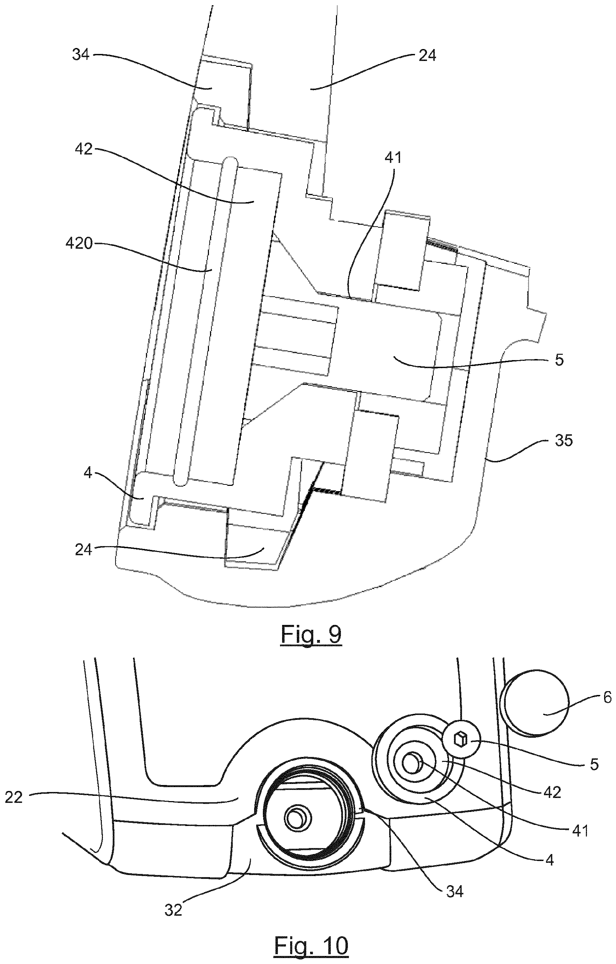

- la figure 9 est une vue de coupe des secondes extrémités de la demi-coque supérieure et de la demi-coque inférieure assemblées pour former le boitier du terminal, montrant l'élément de verrouillage de l'assemblage ;
- la figure 10 montre la seconde extrémité de la demi-coque inférieure et la seconde extrémité de la demi-coque supérieure assemblées pour former le boitier du terminal, et les éléments de verrouillage et de scellement.

### 5. Description d'un mode de réalisation de l'invention

Le principe général de l'invention consiste à assembler les deux demi-coques formant le boitier du terminal de paiement électronique selon un mouvement en deux temps, un premier temps d'engagement d'éléments formant charnière, prévus à une première extrémité de la demi-coque supérieure et de la demi-coque inférieure, et un second temps d'assemblage de la demi-coque supérieure et de la demi-coque inférieure par rotation autour de ces éléments formant charnière.

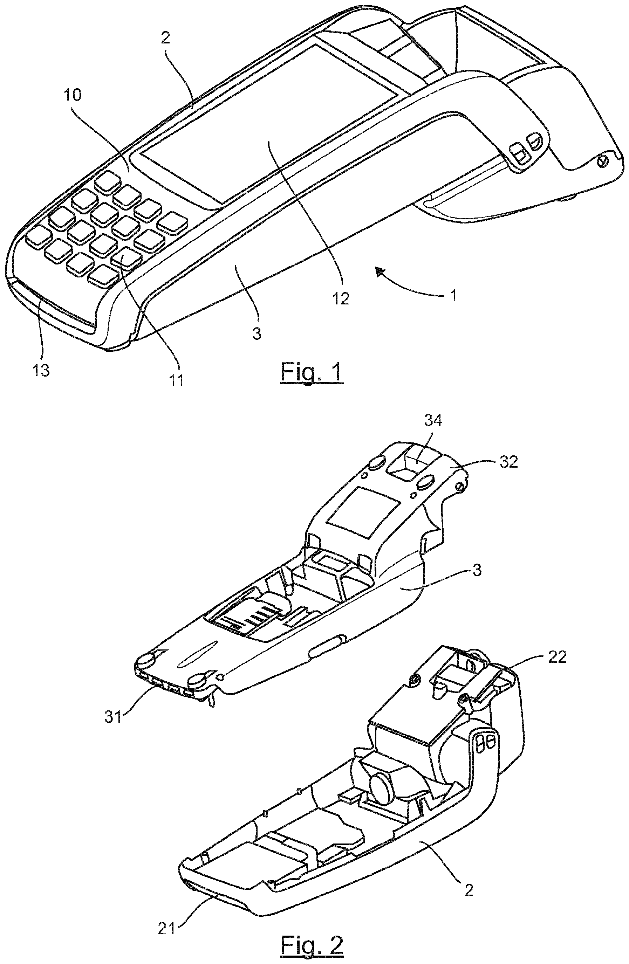

La figure 1 représente un terminal de paiement électronique 1 qui comprend notamment un clavier 11, un écran 12 et un lecteur de carte à puce 13 permettant l'utilisation d'une carte de paiement. Ces différents composants, ainsi que des composants électroniquement visibles, sont regroupés dans un boitier 10 qui est lui-même composé d'une demi-coque supérieure 2 assemblée sur une demi-coque inférieure 3.

La figure 2 représente le terminal électronique de paiement 1 dont le boitier 10 est démonté. La demi-coque supérieure 2 et la demi-coque inférieure 3 sont ainsi séparées, ce qui permet d'accéder aux composants électroniques internes.

Pour permettre l'assemblage de la demi-coque inférieure 3 et de la demi-coque supérieure 2 dans des conditions satisfaisantes de sécurité, des éléments complémentaires formant charnière sont prévus à une première extrémité 31 de la coque inférieure 3 et à une première extrémité 21 de la coque supérieure 2. Par ailleurs, des éléments de verrouillage sont prévus à une seconde extrémité 32, opposée à la première extrémité 31, de la coque inférieure 3 et à la seconde extrémité 22, opposée à la première extrémité 21, de la coque supérieure 2.

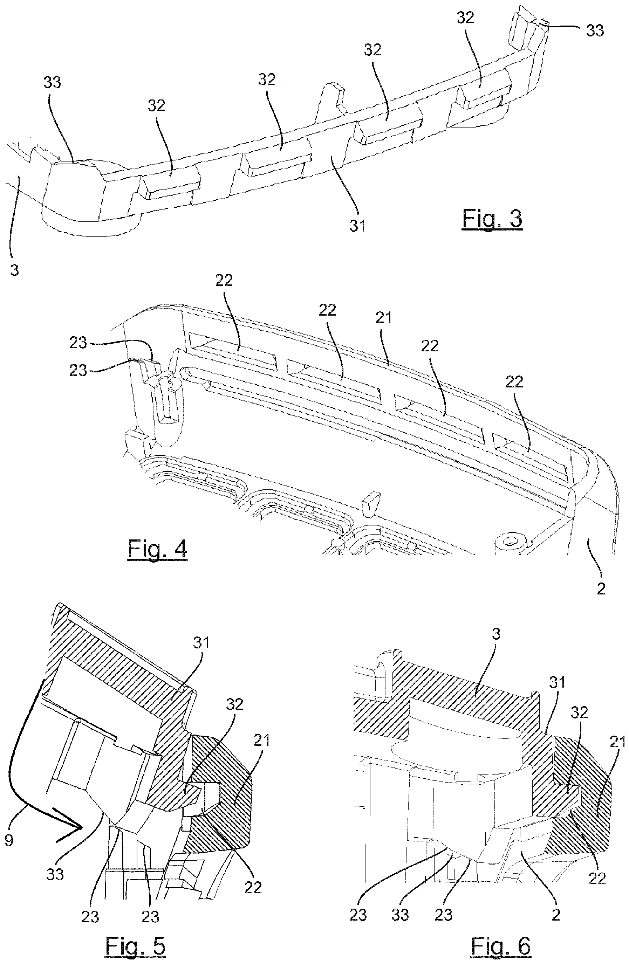

Les figures 3 et 4 montrent respectivement la première extrémité 31 de la coque inférieure 3 et la première extrémité 21 de la coque supérieure 2. Comme le montrent ces figures, la première extrémité 31 de la coque inférieure 3 présente une paroi d'extrémité portant, sur sa surface externe, une série de languettes, ou tenons 32. La première extrémité 21 de la coque supérieure 2 présente également une paroi d'extrémité qui présente, sur sa surface interne, une série de rainures 22, formant des orifices de réception particuliers, adaptés pour recevoir les tenons 32.

La figure 5 représente, en vue de coupe, la première extrémité 21 de la demi-coque supérieure et la première extrémité 31 de la demi-coque inférieure. Comme le montre cette figure, chacune des languettes 32 est prévue pour s'insérer dans une rainure 22 correspondante. L'ensemble des languettes 32 et des rainures 22 peuvent ainsi former une charnière entre la demi-coque supérieure 2 et la demi-coque inférieure 3. Les formes respectives des tenons 32 et des rainures 22 sont en effet choisies pour permettre une rotation d'une demi-coque par rapport à l'autre, autour d'un axe correspondant à la direction longitudinale des tenons, quand les tenons 32 sont insérés dans les rainures 22.

Les bords latéraux de la demi-coque supérieure 2 présentent par ailleurs, à proximité de la première extrémité 21 de cette demi-coque, des butées 23, qui sont prévues pour coopérer avec des portions de butées 33 prévues sur les bords latéraux de la demi-coque inférieure 3. Ces butées coopèrent entre elles pour ne permettre l'insertion des languettes 32 dans les rainures 22, ou le retrait des languettes 32 des rainures 22, que quand les demi-coques supérieure 2 et inférieure 3 forment entre elles un angle suffisamment grand. Une fois les languettes 32 introduites dans les rainures 22, il est possible de faire varier cet angle par rotation autour de la charnière formée par les languettes et les rainures. Cette rotation est représentée par la flèche 9 de la figure 5.

Quand cette rotation entraîne une diminution de l'angle entre la demi-coque supérieure et la demi-coque inférieure, et à fortiori quand les demi-coques inférieure et supérieure sont ramenées l'une contre l'autre, ces butées 23 et 33 coopèrent pour empêcher les languettes 32 de sortir des rainures 22. Ainsi, quand les deux demi-coques du boitier 10 sont assemblées, il est nécessaire, pour désassembler leurs premières extrémités respectives, de faire pivoter l'une des demi-coques par rapport à l'autre, d'un angle suffisant. Tout mouvement de translation entre les demi-coques supérieure 2 et inférieure 3 est bloqué.

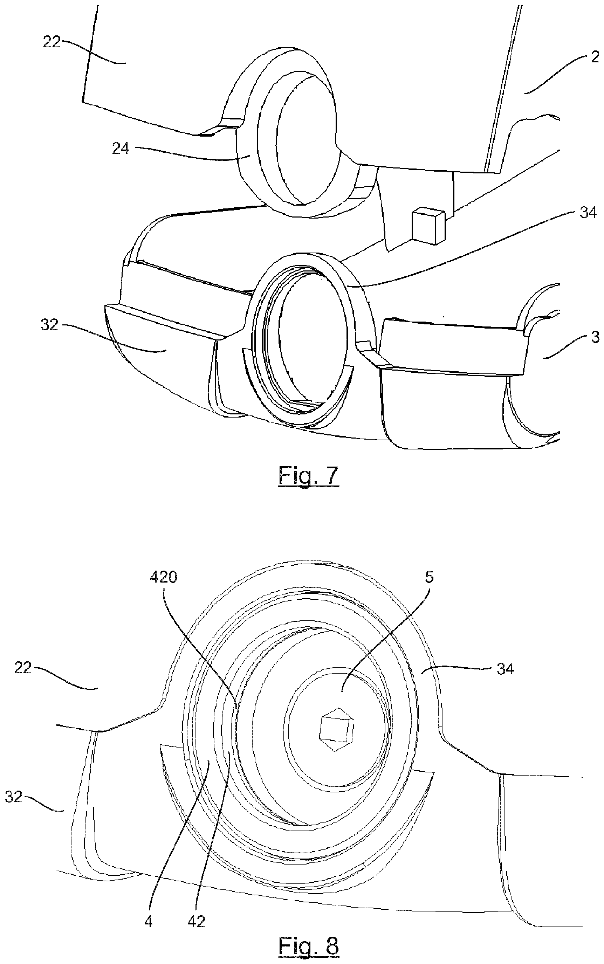

Pour l'assemblage des deux demi-coques, il est donc nécessaire, après avoir assemblé les éléments formant charnière, de venir emboîter la demi-coque supérieure et la demi-coque inférieure par un mouvement de rotation, de façon à fermer le boîtier 10. La figure 7 représente la seconde extrémité 22 de la demi-coque supérieure 2 et la seconde extrémité 32 de la demi-coque inférieure 3. Ces secondes extrémités sont opposées aux premières extrémités des demi-coques. Comme le représente la figure 7, la demi-coque supérieure 2 porte, au niveau de sa seconde extrémité 22, un anneau de verrouillage 24, et la demi-coque inférieure 3 porte, au niveau de sa seconde extrémité 32, un anneau de verrouillage 34. Quand les deux demi-coques se superposent en s'emboîtant l'une sur l'autre, ces deux anneaux de verrouillage se superposent l'un à l'autre, de façon concentrique.

L'ouverture cylindrique formée par ces anneaux s'étend selon un axe dirigé sensiblement vers la charnière formée au niveau des premières extrémités de la demi-coque supérieure et de la demi-coque inférieure. En conséquence, l'introduction d'une cheville 4 dans cette ouverture cylindrique permet, en maintenant les deux anneaux 24 et 34 concentriques, de bloquer la rotation d'une demi-coque par rapport à l'autre, autour de la charnière formée au niveau des premières extrémités de ces demi-coques. Le verrouillage de la position de cette unique cheville 4 permet alors de verrouiller efficacement la fermeture du boîtier constituée par les demi-coques 2 et 3.

Ainsi, si une personne souhaite altérer le fonctionnement du terminal, il doit, pour accéder aux composants internes, débloquer le mouvement de rotation. De plus, pour accéder aux composants situés à proximité de la charnière formée au niveau de la première extrémité des demi-coques, il est nécessaire de réaliser un grand déplacement angulaire d'une des demi-coques par rapport à l'autre.

En conséquence, selon un mode de réalisation préférentiel de l'invention, les composants sensibles du terminal sont regroupés à proximité de cette première extrémité. Ainsi, ces composants sont regroupés dans une enceinte située à proximité du lecteur de carte à mémoire, dont la forme d'introduction de carte à puce est située au niveau de la première extrémité de la demi-coque supérieure. L'accès à ces composants sensibles situé à proximité de l'axe de rotation nécessite donc un angle d'ouverture important. Un tel angle d'ouverture peut facilement être détecté par un dispositif approprié, capable de déclencher la mise hors fonction du terminal.

La cheville 4 qui est introduite dans les deux anneaux 24 et 34 afin de verrouiller l'assemblage du boîtier présente une ouverture axiale 41 permettant l'introduction d'une vis 5. Cette vis 5 permet la fixation de la cheville 4 au boîtier 10.

Un lamage 42 est également prévu dans la cheville 4, de façon à permet l'introduction d'un scellé, ou sceau de contrôle 6 au-dessus de la surface plane de la tête de la vis 5. Ce sceau de contrôle 6, qui permet d'attester que l'intégrité du terminal n'a pas été violée, peut par exemple être constitué en plomb et être introduit par frappage dans le lamage 42. Lors du frappage, le plomb du sceau 6 peut s'introduire dans une rainure interne 420 prévue dans le lamage 42, ce qui assure son maintien efficace dans le lamage 42. Il est ainsi impossible, sans détruire ce sceau, de dévisser la vis 5 et en conséquence de retirer la cheville 4 maintenant assemblé les deux demi-coques formant le boîtier 10.

Pour faciliter l'insertion du sceau 6 par frappage dans le lamage 42, la demi-coque inférieure 3 présente une forme offrant une surface d'appui 34, dans l'alignement de l'axe de la cheville 4, sensiblement perpendiculaire à cet axe, et à proximité de cette cheville. Cette surface d'appui 34 permet d'appuyer le boitier 10 sur une enclume adaptée pour réaliser le frappage du scellé 6 sans risquer de détériorer le terminal.

Dans le mode de réalisation présenté ci-dessus, le verrouillage du boitier est assuré par la cheville 4 de section circulaire introduite dans les ouvertures circulaires des éléments de paroi des demi-coques, qui forment les anneaux de verrouillage. Il est cependant à noter que l'homme du métier peut prévoir dans les éléments de paroi des deux demi-coques des ouvertures de forme différente (par exemple des ouvertures carrées), dans lesquelles est introduite une cheville de forme adaptée (par exemple de section carrée.

## Revendications

1. Terminal de paiement électronique (1) comprenant un boitier (10) formé de deux demi-coques (2, 3) superposées l'une à l'autre, **caractérisées en ce que** chacune desdites demi-coques présente un élément de paroi (24, 34) dans lequel est percée une ouverture de verrouillage, les ouvertures de verrouillage de chacune desdites demi-coques étant superposées l'une à l'autre, et **en ce que** ledit boitier comprend une cheville de verrouillage (4), insérée dans lesdites deux ouvertures de verrouillage superposées afin d'empêcher le déplacement relatif desdits éléments de paroi, dans un plan perpendiculaire à l'axe longitudinal de ladite cheville, caractérisé en qu'il comprend en outre une vis de fixation (5) de ladite cheville (4) audit boitier (10).

2. Terminal de paiement électronique selon la revendication 1 **caractérisé en ce que** ladite vis (5) est introduite dans un perçage axial (41) prévu dans ladite cheville (4).

3. Terminal de paiement électronique selon la revendication 2 **caractérisé en ce que** ladite cheville (4) présente un lamage (42), au-dessus de la tête de ladite vis (5), dans lequel est introduit un sceau de contrôle (6).

4. Terminal de paiement électronique selon la revendication précédente **caractérisé en ce que** ledit lamage (42) présente une rainure interne (420) assurant une solidarisation efficace dudit sceau de contrôle (6).

5. Terminal de paiement électronique selon l'une quelconque des revendications 3 et 4, **caractérisé en ce que** ledit boitier (10) présente, à proximité de ladite cheville (4), une surface d'appui (34) dans l'axe de ladite cheville, sensiblement perpendiculaire à cet axe et orienté dans un sens opposé au sens d'ouverture dudit lamage (42), permettant de former appui pour l'introduction par frappage dudit sceau de contrôle (6) dans ledit lamage.

6. Terminal de paiement électronique selon l'une quelconque des revendications précédentes, **caractérisé en ce que** lesdites ouvertures de verrouillage des deux demi-coques sont constituées par des anneaux de verrouillage (24, 34) formés par lesdits éléments de paroi.

7. Procédé d'assemblage du boitier (10) d'un terminal de paiement électronique (1), **caractérisé en ce qu'**il comprend :
- une étape d'assemblage de deux demi-coques (2, 3), jusqu'à ce qu'un élément de paroi d'une première demi-coque (2), dans lequel est définie une première ouverture de verrouillage, soit placé en regard d'un élément de paroi de la seconde demi-coque (3) dans lequel est définie une seconde ouverture de verrouillage ;
- une étape d'insertion d'une cheville (4) dans lesdites deux ouvertures de verrouillage ;
- une étape d'insertion d'une vis de fixation (5) de ladite cheville (4) audit boitier (10).

## Patentansprüche

1. Elektronisches Zahlungsendgerät (1), umfassend ein Gehäuse (10), das von zwei Halbschalen (2, 3), die übereinander angeordnet sind, gebildet ist, **dadurch gekennzeichnet, dass** jede der Halbschalen ein Wandelement (24, 34) aufweist, in dem eine Verriegelungsöffnung vorgesehen ist, wobei die Verriegelungsöffnungen jeder der Halbschalen übereinander angeordnet sind, und dass das Gehäuse einen Verriegelungsbolzen (4) umfasst, der in die zwei übereinander angeordneten Verriegelungsöffnungen eingesetzt ist, um die relative Verschiebung der Wandelemente in einer Ebene senkrecht auf die Längsachse des Bolzens zu verhindern, **dadurch gekennzeichnet, dass** es ferner eine Schraube (5) zur Befestigung des Bolzens (4) am Gehäuse (10) umfasst.

2. Elektronisches Zahlungsendgerät nach Anspruch 1, **dadurch gekennzeichnet, dass** die Schraube (5) in eine axiale Bohrung (41), die in dem Bolzen (4) vorgesehen ist, eingeführt wird.

3. Elektronisches Zahlungsendgerät nach Anspruch 2, **dadurch gekennzeichnet, dass** der Bolzen (4) eine Senkung (42) über dem Kopf der Schraube (5) aufweist, in die ein Prüfsiegel (6) eingeführt wird.

4. Elektronisches Zahlungsendgerät nach dem vorhergehenden Anspruch, **dadurch gekennzeichnet, dass** die Senkung (42) eine Innennut (420) aufweist, die eine wirksame Befestigung des Prüfsiegels (6) gewährleistet.

5. Elektronisches Zahlungsendgerät nach einem der Ansprüche 3 und 4, **dadurch gekennzeichnet, dass** das Gehäuse (10) in der Nähe des Bolzens (4) eine Stützfläche (34) in der Achse des Bolzens im Wesentlichen senkrecht zu dieser Achse und in eine zur Öffnungsrichtung der Senkung (42) entgegengesetzte Richtung ausgerichtet umfasst, die es ermöglicht, eine Abstützung für die Einführung des Prüfsiegels (6) durch Prägen in die Senkung zu bilden.

6. Elektronisches Zahlungsendgerät nach einem der vorhergehenden Ansprüche, **dadurch gekennzeichnet, dass** die Verriegelungsöffnungen der zwei Halbschalen von Verriegelungsringen (24, 34) dargestellt sind, die von den Wandelementen gebildet sind.

7. Verfahren zum Zusammenbau des Gehäuses (10) eines elektronischen Zahlungsendgeräts (1), **dadurch gekennzeichnet, dass** es umfasst:
- einen Schritt des Zusammenbaus von zwei Halbschalen (2, 3), bis ein Wandelemente einer ersten Halbschale (2), in der eine erste Verriegelungsöffnung definiert ist, gegenüber einem Wandelement der zweiten Halbschale (3), in der eine zweite Verriegelungsöffnung definiert ist, angeordnet ist;
- einen Schritt des Einsetzens eines Bolzens (4) in die zwei Verriegelungsöffnungen;
- einen Schritt des Einsetzens einer Schraube (5) zur Befestigung des Bolzens (4) am Gehäuse (10).

## Claims

1. Electronic payment terminal (1) comprising a housing (10) formed by two half-shells (2, 3) superimposed on each other, **characterised in that** each of said half-shells has a wall element (24, 34) in which a locking opening is drilled, the locking openings of each of said half-shells being superimposed on each other, and **in that** said housing comprises a locking pin (4), inserted into the said two superimposed locking openings to prevent the relative displacement of said wall elements, in a plane perpendicular to the longitudinal axis of said pin, **characterised in that** it also comprises a screw (5) for fixing said pin (4) to said housing (10).

2. Electronic payment terminal according to claim 1, **characterised in that** said screw (5) is inserted into an axial bore (41) provided in said pin (4).

3. Electronic payment terminal according to claim 2, **characterised in that** said pin (4) has a counterbore (42) above the head of said screw (5), into which a control seal (6) is introduced.

4. Electronic payment terminal according to the preceding claim, **characterised in that** said counterbore (42) has an internal groove (420) ensuring an effective coupling of said control seal (6).

5. Electronic payment terminal according to any one of claims 3 and 4, **characterised in that** said housing (10) has, in the vicinity of said pin (4), a support surface (34) in the axis of said pin, substantially perpendicular to this axis and oriented in a direction opposite to the direction of opening of said counterbore (42), enabling the formation of support for the insertion by striking of said control seal (6) into said counterbore.

6. Electronic payment terminal according to any one of the preceding claims, **characterised in that** said locking openings of the two half shells are constituted by locking rings (24, 34) formed by said wall elements.

7. Method for assembling the housing (10) of an electronic payment terminal (1), **characterised in that** it comprises:
- a step of assembling two half-shells (2, 3), until a wall element of a first half-shell (2), in which a first locking opening is defined, either placed opposite a wall element of the second half-shell (3) in which a second locking opening is defined;
- a step of inserting a pin (4) into said two locking openings;
- a step of inserting a fixing screw (5) of said pin (4) into said housing (10).
